Europäisches Patentamt

European Patent Office

Office européen des brevets

(19)

(11) Publication number: **0 035 690**

**B1**

(12) EUROPEAN PATENT SPECIFICATION

(45) Date of publication of patent specification: **12.10.88**

(51) Int. Cl.⁴: **H 01 L 21/76, H 01 L 21/31**

(21) Application number: **81101328.3**

(22) Date of filing: **24.02.81**

(54) Semiconductor device using component insulation and method of manufacturing the same.

(30) Priority: **06.03.80 JP 27310/80**
**06.03.80 JP 27311/80**
**12.03.80 JP 30307/80**

(43) Date of publication of application:
**16.09.81 Bulletin 81/37**

(45) Publication of the grant of the patent:
**12.10.88 Bulletin 88/41**

(84) Designated Contracting States:
**DE FR GB NL**

(56) References cited:
**GB-A-2 021 860**

**IEEE TRANSACTIONS ON ELECTRON DEVICES, vol. ED-26, no. 4, April 1979, pages 385-389, IEEE, New York, US; K. OKADA et al.: "A new polysilicon process for a bipolar device - PSA technology"**

**IEEE TRANSACTIONS ON ELECTRON DEVICES, vol. ED-27, no. 1, January 1980, pages 290-293, IEEE, New York, US; T.I. KAMINS et al.: "A monolithic integrated circuit fabricated in laser-annealed polysilicon"**

(73) Proprietor: **KABUSHIKI KAISHA TOSHIBA**
**72, Horikawa-cho Saiwai-ku**
**Kawasaki-shi Kanagawa-ken 210 (JP)**

(72) Inventor: **Nozawa, Hiroshi**
**1-604, Minesawa-danchi 105 Minesawa-cho**
**Hodogaya-ku Yokohama-shi (JP)**

(74) Representative: **Henkel, Feiler, Hänzel & Partner**
**Möhlstrasse 37**
**D-8000 München 80 (DE)**

(56) References cited:

**JAPANESE JOURNAL OF APPLIED PHYSICS, vol. 18, supplement 18-1, 1979, pages 45-50, Tokyo, JP; J. SAKURAI: "An isolation structure and layout of the buried-oxide CMOS-IC"**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a method for manufacturing a semiconductor device and, more particularly, to an element isolation method using insulating materials.

As isolation techniques in semiconductor integrated circuits, there are generally known methods in which the isolation regions are formed by selective oxidation for facilitating higher packing density and a more effective manufacturing process. According to such methods, since the periphery of the active region is surrounded by the oxide layer, self-alignment is possible by methods such as base diffusion so that unnecessary parts which have been conventionally required for masking may be eliminated. This allows higher packing density. Furthermore, since the sides comprise deep oxide layers, the coupling capacitance is significantly reduced. However, this method adopts a structure according to which the thermally oxidized layer is selectively embedded in the silicon substrate. This causes great strain in the silicon substrate, degrades the electrical characteristics of the element, and thus imposes strict limits as to selection of the structure, configuration, film thickness, the conditions for selective oxidation of the oxidation mask, and occasionally on the selection of the material itself for the silicon substrate. This is disclosed, for example, in IEDM, "High Pressure Oxidation of Isolation of High Speed Bipolar Devices", pp. 340 to 343, 1979.

In the conventional element isolation technique utilizing insulating material, the field oxidizing time is long. This significantly gives rise to the diffusion and redistribution of the impurity layer in the channel stopper. For example, when the diffusion in the transverse direction is great, the effective channel width of the MOS transistor is reduced and the drain coupling capacitance increases, thus obstructing realization of a high speed device. The implanted ion dose must be increased or the accelerating voltage must be made greater to compensate for the redistribution of the impurity in the oxide layer. This leads to degradation of the yield through damage caused by the ion implantation. When annealing is performed using the nitride layer as a mask, a silicon nitride layer called a "white ribbon", is formed in the silicon substrate below the nitride layer, leading to defective voltage resistance of the element.

Prior art document GB—A—2 021 860 discloses a method for manufacturing field effect transistors. In this method a doped polysilicon layer is deposited over a silicon wafer. Well spaced source, drain and gate contact areas are masked with a silicon nitride layer, and the remainder of the polysilicon layer is thermally oxidized to form field oxide extensions and contact insulating regions.

It is an object of the present invention to provide a method for manufacturing a semiconductor device employing element isolation utilizing insulating materials which is advantageous for higher packing density, which prevents degradation of the electrical characteristics by thermal stress in the semiconductor substrate, which also prevents disconnections of the wiring, and which provides excellent reliability and yield.

The present invention provides a method for manufacturing a semiconductor device employing element isolation of an active region in a semiconductor substrate by forming insulating materials, said method comprising the steps of:

(a) forming an oxidizable material layer on a surface of the semiconductor substrate;

(b) forming an oxidation mask on a portion of said oxidizable material layer overlying said active region;

(c) oxidizing part or whole of said oxidizable material layer not covered with said oxidation mask forming an oxide layer for element isolation;

(d) removing said oxidation mask;

(e) partially exposing the surface of said semiconductor substrate by removing at least part of said oxidizable material layer exposed by said step of removing said oxidation mask; and

(f) forming a semiconductor element in said exposed surface of said semiconductor substrate.

This invention can be more fully understood from the following detailed description when taken in conjunction with the accompanying drawings, in which:

Figs. 1(a) to 1(f) are sectional views illustrating one embodiment of the method according to the present invention in sequential order;

Figs. 2(a) to 2(f) are sectional views illustrating another embodiment of the method according to the present invention in sequential order;

Figs. 3(a) to 3(d) are sectional views illustrating an embodiment for manufacturing a high voltage resistant MOS transistor utilizing the method according to the present invention in sequential order;

Fig. 4 is a plan view of Fig. 3(d);

Figs. 5(a) to 5(d) are sectional views illustrating an embodiment where the method of the present invention is applied in sequential order to the manufacture of a dynamic type MOS RAM;

Fig. 6 is a plan view of Fig. 5(d);

Figs. 7(a) to 7(d) are sectional views illustrating an embodiment where the method of the present invention is applied in sequential order to the manufacture of an EPROM;

Fig. 8 is a partial, schematic perspective view of an EPROM element according to the present invention; and

Fig. 9 is a partial, schematic plan view of an EPROM element corresponding to Fig. 8.

The oxidizable material in the present specification means materials such as non-monocrystalline silicon or the like which may be oxidized at a relatively fast speed, for example, at a speed faster than that for oxidizing the semiconductor substrate used. The oxidizable material may contain an impurity at a high concentration or may not substantially contain an impurity. The active region, in this specification, is taken to mean regions of active elements such as FET type transistors or the like, as well as semiconductor element-forming regions for passive elements such as resistors and capacitive elements.

The present invention will now be described in more detail with reference to its examples.

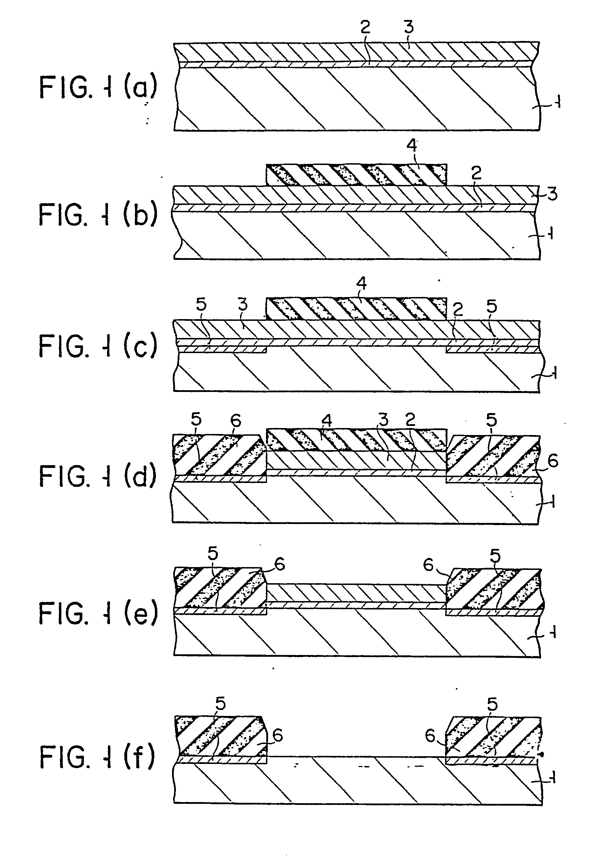

Figs 1(a) to 1(d) are schematic sectional views for explaining in detail the present invention. As shown in Fig. 1(a), an insulation layer such as an oxide layer 2 of 100nm (1,000Å) thickness is formed on a semiconductor substrate such as an n-type monocrystalline silicon substrate 1. Although an n-type monocrystalline silicon substrate is used in the description of the present invention, it is to be understood that a p-type monocrystalline silicon substrate may be used and a compound semiconductor may also be used. Although the formation of the oxide layer 2 is preferable to avoid adverse effects which might otherwise result, it is not necessary. A polycrystalline silicon layer 3 of 0.4 µm thickness containing phosphorus to a high concentration (e.g., $1 \times 10^{20}/cm^3$) is formed on the oxide layer 2 by chemical vapor deposition in a $PH_3$ atmosphere as a material layer. Instead of polycrystalline silicon, molybdenum silicide or tungsten silicide may be used. Instead of phosphorus, the high concentration impurity may be boron, arsenic or the like. Furthermore, it is possible to add the impurity in the silicon source while simultaneously forming the polycrystalline silicon layer. Then, as shown in Fig. 1(b), a silicon nitride layer as an oxidation mask is formed to a thickness of 100 nm to 300 nm (1,000 to 3,000 Å) by chemical vapor deposition. The part of the silicon nitride layer to become the channel stopper region is removed by photoetching to provide an oxidation mask 4. As shown in Fig. 1(c), ion implantation is performed using this silicon nitride layer 4 as a mask to form an impurtiy layer of the same conductivity type as the substrate to provide channel stoppers 5. In this case, a photoresistant mask used for forming the oxidation mask may be used as the impurity doping mask. The doping of the impurity in the polycrystalline silicon layer 3 as shown in Fig. 1(a) may be performed simultaneously with the formation of the channel stoppers using the silicon nitride layer 4 as a mask, or it may be performed in a separate process by ion implantation. Depending upon the purpose, the formation of the channel stoppers 5 may be eliminated if not necessary. Then, as shown in Fig. 1(d), the polycrystalline silicon layer 3 is selectively oxidized to form thick oxide layers 6 of about 800 nm (8,000 Å) thickness for isolating the elements. As shown in Fig. 1(e), the silicon nitride layer 4 used as the oxidation mask is removed by dry etching. Thereafter, the polycrystalline silicon layer 3 and the oxide layer 2 are selectively etched. After predetermined processing, the structure may be used for the manufacture of ROMs (read-only memory).

Alternatively, as shown in Fig. 1(f), the silicon nitride layer 4 and the unoxidized portion of the polycrystalline silicon layer 3 are removed by dry etching. The oxide layer 2 which was interposed between the polycrystalline silicon layer 3 and the semiconductor substrate 1 is removed by an ammonium fluoride solution to expose part of the surface of the semiconductor substrate. Thereafter, a series of processes including oxidation, diffusion and so on are performed to form semiconductor elements such as MOS transistors, bipolar transistors and so on.

In the above embodiment, the polycrystalline silicon layer was selectively oxidized on the surface of the semiconductor substrate. Another embodiment will now be described wherein the polycrystalline silicon layer is interposed between a thick oxide layer and the oxide layer formed on the substrate in order to be used as a shield layer.

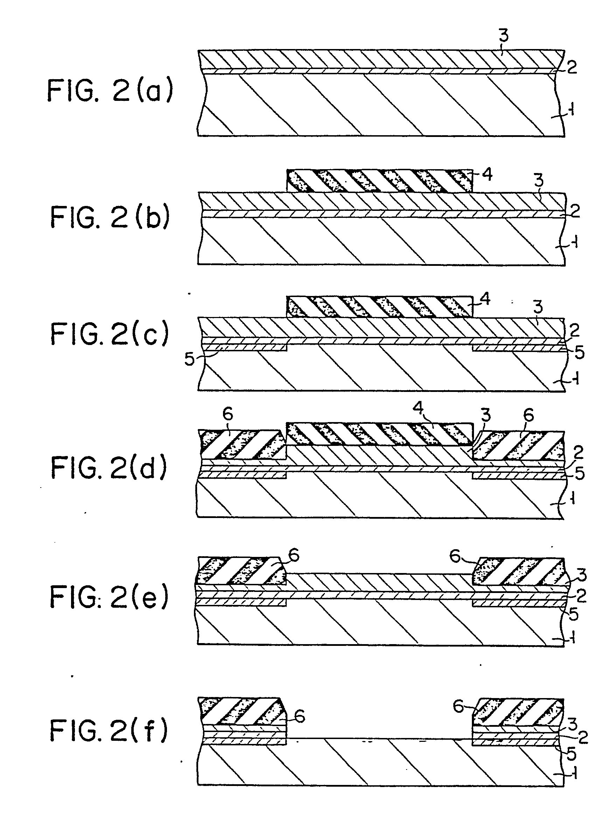

First, as shown in Fig. 2(a), the oxide layer 2 of about 100 nm (1,000 Å) thickness and the polycrystalline silicon layer 3 of about 0.6 µm thickness and containing phosphorus to a high concentration are formed by the same process as in Fig. 1(a). As compared with the above embodiment, the polycrystalline silicon layer 3 is formed thicker to leave a shield layer.

Next, as shown in Fig. 2(b), the silicon nitride layer 4 as the oxidation mask is formed by the same process as in Fig. 1(b).

If necessary, as shown in Fig. 2(c), ion implantation is performed using the silicon nitride layer 4 as a mask to form the impurity regions 5 of the same conductivity type as the substrate to provide the channel stoppers 5. As shown in Fig. 2(d), the polycrystalline silicon layer 3 is selectively oxidized using the silicon nitride layer 4 as a mask. By oxidizing the polycrystalline silicon layer, thick oxide layers 6 of about 800 nm (8,000 Å) thickness for isolation of elements are embedded in the polycrystalline silicon layer 3. The polycrystalline silicon layers of about 0.2 µm thickness are left unoxidized below the thick oxide layers 6.

Then, as shown in Fig. 2(e), the silicon nitride layer 4 used as the oxidation mask is removed by plasma etching. Thereafter, the polycrystalline silicon layer 3 and the oxide layer 2 are selectively etched. After predetermined processing, this structure may be used for the manufacture of high voltage resistant MOS transistors or the like.

Alternatively, as shown in Fig. 2(f) the silicon nitride layer 4 used as the oxidation mask and the polycrystalline silicon layer 3 not covered with the thick oxide layers are removed by dry etching. The oxide layer 2 which was interposed between the polycrystalline silicon layer 3 and the semiconductor substrate 1 is removed with an ammonium fluoride solution to partially expose the surface of the substrate.

Thereafter, a series of processes such as oxidation, diffusion and so on are performed on the surface of the substrate. The polycrystalline silicon layer 3 below the thick oxide layers 6 are wired to be used as a shield layer to form semiconductor elements such as MOS transistors, bipolar transistors and so on.

Accordingly, since the oxidizable material such as polycrystalline silicon is selectively oxidized to form thick oxide layers, defects due to stress may be caused in the oxidizable material but not in the substrate. For this reason, a semiconductor element having excellent characteristics may be manufactured, providing a method for manufacturing a semiconductor device with high reliability and yield.

Since a layer containing only silicon nitride may be used as the oxidation mask, the length of the bird's beak becomes short, which is advantageous for achieving higher packaging density. When the photoresist is used as the impurity doping mask, the element forming regions and the channel stoppers are isolated by forming the silicon nitride layer with a smaller area than the photoresist area. By diffusing the impurity to a high concentration, the oxidizing speed of the oxidizable material becomes high, resulting in economy. This also shortens the time for the heat treatment of the elements, so that the performance is improved and adverse effects by thermal stress may be prevented. The same effects may be obtained even if the impurity is not diffused.

The non-monocrystalline silicon layer such as the polycrystalline silicon layer below the thick oxide layers, has a small specific resistance. Thus, it functions as part of the internal wiring by capacitance division of the potential even when the wiring is not connected, so that high voltage resistance may be provided, resistance to outside contamination such as Na ions may be strengthened, and higher reliability may be obtained. In addition to this, since the field oxidation time is short, the transverse diffusion of the channel stoppers becomes small so that the effective channel width in the MOS transistor becomes great, the drain coupling capacitance becomes small, and high speed operation is realized. Since the semiconductor substrate is not oxidized, diffusion of the impurity into the oxide layer by redistribution may be decreased. The dose of the ion impurity may be made smaller for this reason, providing a method for manufacturing a semiconductor device according to which the damage due to ion implantation may be smaller and the yield may be greater..

Although the silicon nitride layer was used as the oxidation mask in the above embodiment, one or more layers of known oxidation mask such as alumina may alternatively be formed.

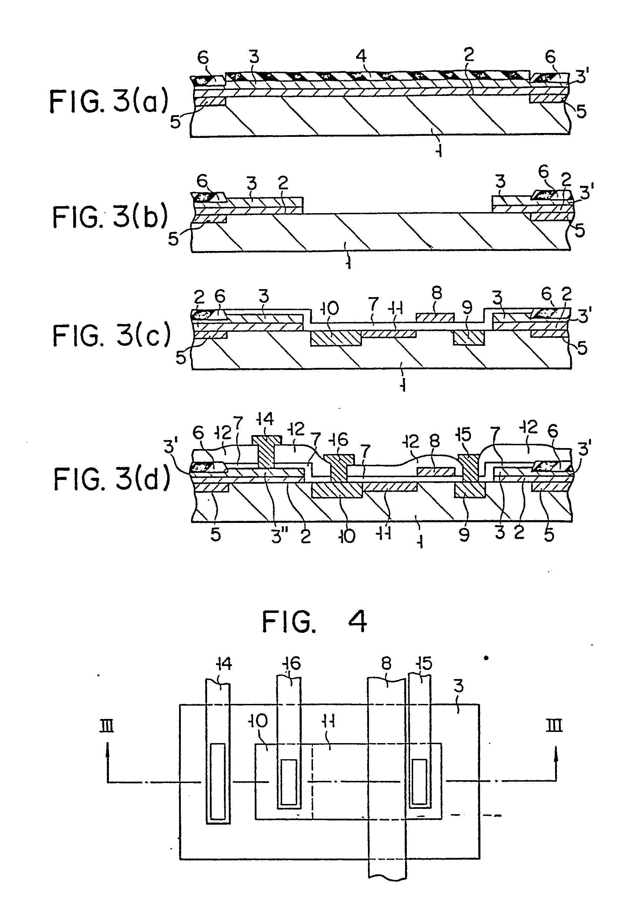

A description will now be made of an embodiment in which the method of the present invention is applied to a high voltage resistant MOS transistor integrated circuit, referring to Figs. 3(a) to 3(d). According to the same procedure as in Figs. 2(a) to 2(d), as shown in Fig. 3(a), ion implantation is performed using the silicon nitride layer as a mask to form the channel stoppers 5, which are high impurity concentration layers of the same conductivity type as the substrate 1, while simultaneously doping the impurity into the polycrystalline silicon layer 3. Thereafter, the thick oxide layers 6 of about 800 nm (8,000 Å) thickness are formed for isolation of the elements, leaving an unoxidized polycrystalline silicon layer 3' of about 0.2 µm thickness.

Then, as shown in Fig. 3(b), the silicon nitride layer 4 used as the oxidation mask is removed by dry etching, and the polycrystalline silicon layer not covered with the exposed thick oxide layers 6 is selectively removed by dry etching. The oxide layer 2 which was interposed between the polycrystalline silicon layer 3 and the semiconductor substrate is removed with an ammonium fluoride solution to partially expose the surface of the semiconductor substrate. Thereafter, as shown in Fig. 3(c), a gate oxide layer 7 is formed by annealing to a thickness of 100 nm (1,000 Å). The exposed part of the polycrystalline silicon layer 3 is simultaneously covered with the oxide layer 7. The polycrystalline silicon layer is then subjected to chemical vapor deposition to dope an impurity for forming a gate electrode 8 by photolithography. This gate electrode 8 is insulated from the polycrystalline layer by the oxide layer 7. Diffusion of an impurity of opposite conductivity type to that of the substrate is performed such that the drain side has an offset gate structure to form a source 9 and a drain 10. Ion implantation is performed in offset gate part 11 to form a region of a lower concentration than the drain 10. Finally, as shown in Fig. 3(d), insulation C.V.D. silicon oxide layers 12 are formed. Electrode-connecting holes to a protective gate 3", the gate 8, the source 9, and the drain 10 are formed by photolithography. Internal wirings 14, 15 and 16 are arranged by the patterning of metal layers such as aluminum to complete the structure.

Fig. 4 is a schematic plan view of Fig. 3(d). Fig. 3(d) corresponds to a schematic sectional view along the line III—III' of Fig. 4.

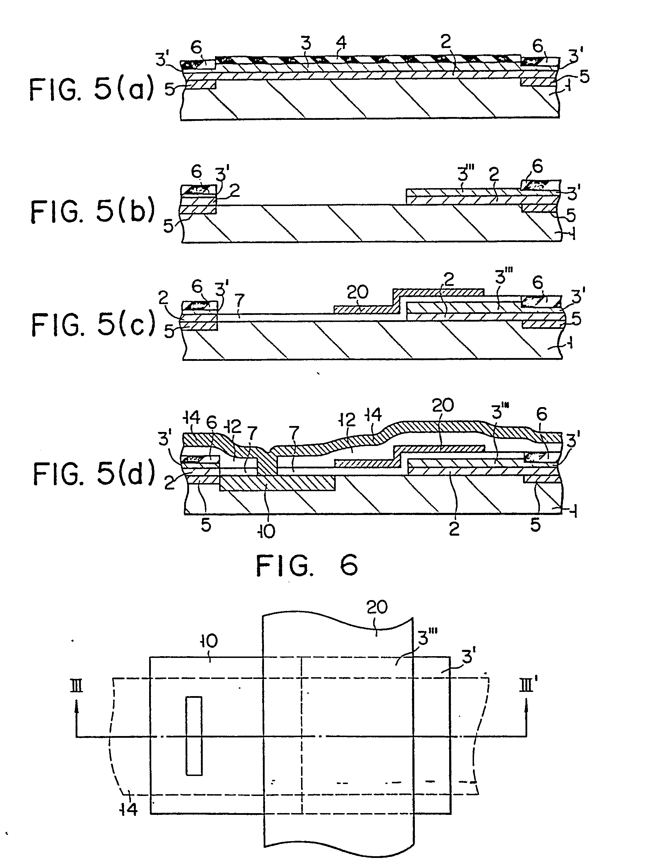

Referring to Figs 5(a) to 5(d), an embodiment will now be described wherein the present invention is applied to a dynamic type MOS RAM Fig. 5(a) corresponds to Figs. 2(a) to 2(d). As shown in Fig. 5(b), the silicon nitride layer 4 used as the oxidation mask is removed by dry etching, and the polycrystalline silicon layer 3 not covered by the exposed thick oxide layers 6 is selectively removed by dry etching. This process is performed so that the remaining polycrystalline silicon layer not covered by the thick oxide layers can be used as an electrode 3''' of a capacitor for storing charge. This one electrode 3''' of the capacitor is formed along the border between the thick oxide layers and the active layers. The oxide layer 2 exposed by the selective etching of the polycrystalline silicon layer 3 is removed by an ammonium fluoride solution to partially expose the surface of the semiconductor substrate. Thereafter, as shown in Fig. 5(c), the gate oxide layer 7 is formed by oxidizing to a thickness of about 100 nm (1,000 Å). The exposed part of the polycrystalline silicon layer (one electrode 3''') is covered with the gate oxide layer 7. Thereafter, the polycrystalline silicon layer is subjected to the chemical vapor deposition and an impurity is doped to form a gate electrode 20 for word line selection by photolithography. The electrode 3'''

of the capacitor for storing charge and the gate electrode 20 are insulated from each other by the oxide layer 7. The potential of the electrode 3''' of the capacitor for storing charge is supplied by the polycrystalline silicon layer 3' below the thick oxide layers 6. Finally, as shown in Fig. 5(d), an impurity of different conductivity type from that of the semiconductur substrate 1 is doped to form the drain 10 using the polycrystalline silicon of 3', 3''' and 20 and the thick oxide layers 6. Thereafter, the insulation C.V.D. silicon oxide layers 12 are grown. The electrode-connecting holes to the drain 10, the gate electrode 20, and the electrode 3''' of the capacitor are formed by photolithography. The internal wiring 14 is arranged by the patterning of metal layers such as aluminum to complete the structure.

Fig. 6 is a schematic plan view of Fig. 5(d). Fig. 5(d) is a schematic sectional view along the line III—III' of Fig. 6.

Since the polycrystalline silicon layer is formed with thick parts and thin parts in this construction, the oxide layers on the thick parts may be made thinner than in the conventional case, facilitating the formation of the electrodes such as the protective gate layer. With the thin parts of the polycrystalline silicon layer, the oxide layers formed thereon become thicker. When the channel stoppers are formed thereover, formation of an inverted layer at the surface of the substrate below the oxide layer may be more effectively prevented. Since the thick and thin parts of the polycrystalline layer are effectively combined, a semiconductor device may be provided according to which the surface of the semiconductor substrate becomes smooth, disconnections of the wirings are reduced, the yield and reliability are improved, and the packaging density is increased.

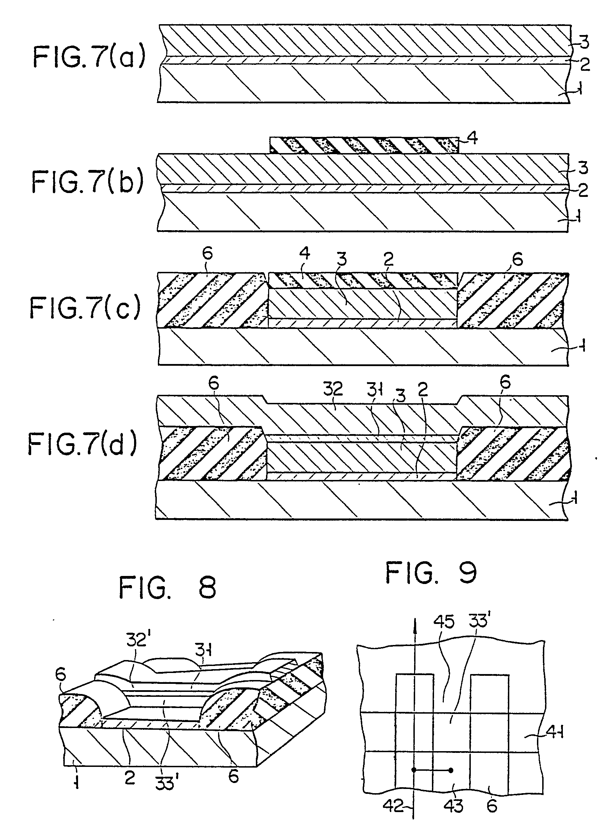

Referring to Figs. 7(a) to 7(d), a description will now be made of an embodiment wherein the method of the present invention is applied to the manufacture of an EPROM (Electrically Programmable Read Only Memory).

As shown in Fig. 7(a), an insulation layer such as the oxide layer 2 of about 100 nm (1,000 Å) thickness is formed on the surface of a semiconductor substrate such as the n-type monocrystalline silicon substrate 1. Thereafter, a conductive material layer which oxidizes fast such as the polycrystalline silicon layer 3 of about 0.4 μm thickness is formed by chemical vapor deposition in a $PH_3$ atmosphere on the oxide layer 2 to form a first monocrystalline silicon layer containing phosphorus to a high concentration. Then, as shown in Fig. 3(b), the silicon nitride layer is formed by chemical vapor deposition to a thickness of 100 to 300 nm (1,000 to 3,000 Å) to provide the oxidation mask 4. As shown in Fig. 7(c), the polycrystalline silicon layer 3 is selectively oxidized using this silicon nitride layer 4 as a mask. By oxidizing the polycrystalline silicon layer, the field oxide layers 6 of about 800 nm (8,000 Å) thickness are formed for isolation of elements.

The silicon nitride layer 4 used as the acid-resistant mask is removed. For using a second polycrystalline silicon layer as the gate of peripheral circuits, it is possible to remove the first surrounding polycrystalline silicon layer 3 and the oxide layer 2. A polycrystalline silicon oxide layer 31 is formed by oxidation, and a second polycrystalline silicon layer 32 is formed thereafter. Using a photoresist, the second polycrystalline silicon layer 32 is selectively etched to form a control gate 32' as shown in Fig. 8. Using the same photoresist, a floating gate 33' is formed by the self-alignment etching technique of the polycrystalline silicon oxide layer 31 and the first polycrystalline silicon layer 3. Fig. 8 is a partial, schematic perspective view of Fig. 7(d) and illustrates the selective etching of the second polycrystalline silicon layer 32 and the first polycrystalline silicon layer 3. After processes such as oxidation, diffusion, CVD, and vapor evaporation required for formation of the elements, an EPROM is completed.

Fig. 9 is a schematic plan view illustrating part of an element of this EPROM wherein electrons are implanted into the floating gate 33' for programming by selecting a drain region 43 through a word line 41 and a data line 42. A source region 45 is grounded. The parts between the elements are insulated by the field oxide layers 6. As may be apparent from Fig. 9, in the EPROM of the present invention, by the smooth floating gate terminal, the area of the floating gate is significantly reduced, the packaging density is greatly increased, and the storage of charge and reliability are improved.

The present invention is not limited to EPROMs, but may be applied to FAMOS type semiconductors which do not have control gates.

## Claims

1. A method for manufacturing a semiconductor device employing element isolation of an active region in a semiconductor substrate by forming insulating materials, said method comprising the steps of:

(a) forming an oxidizable material layer (3) on a surface of the semiconductor substrate (1);

(b) forming an oxidation mask (4) on a portion of said oxidizable material layer (3) overlying said active region;

(c) oxidizing part or whole of said oxidizable material layer (3) not covered with said oxidation mask (4) forming an oxide layer (6) for element isolation;

(d) removing said oxidation mask (4);

(e) partially exposing the surface of said semiconductor substrate (1) by removing at least part of said oxidizable material layer (3) exposed by said step of removing said oxidation mask (4); and

(f) forming a semiconductor element in said exposed surface of said semiconductor substrate (1).

2. A method according to claim 1, wherein a step of doping an impurity into an oxide layer-forming region of said semiconductor substrate (1) is performed before the step of oxidizing part or whole of said oxidizable material layer (3).

3. A method according to claim 1, wherein an oxide layer (2) is interposed between said semiconductor substrate (1) and said oxidizable material layer (3).

4. A method according to claim 1, wherein said oxidation mask (4) is made of silicon nitride.

5. A method according to claim 2, wherein a photoresist for forming said oxidation mask (4) is used as the doping mask in the step of doping the impurity.

6. A method according to claim 5, wherein the area of said oxidation mask (4) is larger than that of said photoresist.

7. A method according to claim 1, wherein the step of oxidizing part of said oxidizable material layer (3) results in forming an oxide layer as an upper layer and forming an unoxidized shield layer as a lower layer.

8. A method according to any of claims 1 to 7, wherein said oxidizable material is non-monocrystalline silicon.

9. A method according to any of claims 1 to 7, wherein said oxidizable material is a material which oxidizes faster than said semicoductor substrate (1).

10. A method according to claim 9, wherein said material which is oxidized faster than said semiconductor substrate (1) is at least one member selected from the group consisting of polycrystalline silicon of high impurity concentration, molybdenum silicide, and tungsten silicide.

11. A method according to claim 1, wherein an upper layer of said oxidizable material exposed by the step of removing said oxidation mask is oxidized after the step (e), and before the step (f).

**Patentansprüche**

1. Verfahren zur Herstellung einer Halbleitervorrichtung unter Elementisolierung eines aktiven Bereichs in einem Halbleitersubstrat mittels Isoliermaterialien, gekennzeichnet durch folgende Stufen:

(a) Ausbilden einer Schicht (3) aus oxidierbarem Material auf einer Oberfläche des Halbleitersubstrats (1);

(b) Ausbilden einer Oxidationsmaske (4) auf einem den aktiven Bereich abdeckenden Teil der Schicht (3) aus oxidierbarem Material;

(c) Oxidieren der gesamten oder eines Teils des nicht mit der Oxidationsmaske (4) bedeckten Schicht (3) aus oxidierbarem Material unter Bildung einer Oxidschicht (6) zur Elementisolierung;

(d) Entfernen der Oxidationsmaske (4);

(e) teilweises Freilegen der Oberfläche des Halbleitersubstrats (1) durch Entfernen mindestens eines Teils der durch die Entfernung der Oxidationsmaske (4) freigelegten Schicht (3) aus oxidierbarem Material und

(f) Ausbilden eines Halbleiterelements in der freigelegten Oberfläche des Halbleitersubstrats (1).

2. Verfahren nach Anspruch 1, dadurch gekennzeichnet, daß vor der teilweisen oder vollständigen Oxidation der Schicht (3) aus oxidierbarem Material eine Fremdatomdotierung eines oxidschichtbildenden Bereichs des Halbleitersubstrats (1) durchgeführt wird.

3. Verfahren nach Anspruch 1, dadurch gekennzeichnet, daß zwischen dem Halbleitersubstrat (1) und der Schicht (3) aus oxidierbarem Material eine Oxidschicht (2) eingefügt wird.

4. Verfahren nach Anspruch 1, dadurch gekennzeichnet, daß die Oxidationsmaske (4) aus Siliziumnitrid hergestellt wird.

5. Verfahren nach Anspruch 2, dadurch gekennzeichnet, daß als Dotiermaske bei der Fremdatomdotierung eine Photoresist zur Ausbildung der Oxidationsmaske (4) verwendet wird.

6. Verfahren nach Anspruch 5, dadurch gekennzeichnet, daß der Bereicht der Oxidationsmaske (4) größer ist als derjenige des Photoresists.

7. Verfahren nach Anspruch 1, dadruch gekennzeichnet, daß die teilweise Oxidation der Schicht (3) aus oxidierbarm Material zur Bildung einer Oxidschicht als oberer Schicht und einer nicht-oxidierten Abschirmschicht als unterer Schicht führt.

8. Verfahren nach einem der Ansprüche 1 bis 7, dadurch gekennzeichnet, daß das oxidierbare Material aus nichtmonokristallinem Silizium besteht.

9. Verfahren nach einem der Ansprüche 1 bis 7, dadurch gekennzeichnet, daß das oxidierbare Material aus einer Substanz besteht, die rascher oxidiert als das Halbleitersubstrat (1).

10. Verfahren nach Anspruch 9, dadurch gekennzeichnet, daß die Substanz, die rascher oxidiert als das Halbleitersubstrat (1) aus mindestens einem Bestandteil der Gruppe polykristallines Silizium hoher Fremdatomkonzentration, Molybdänsilicid und Wolframsilicid besteht.

11. Verfahren nach Anspruch 1, dadurch gekennzeichnet, daß eine Durch die Entfernung der Oxidationsmaske freigelegte obere Schicht aus dem oxidierbaren Material nach Stufe (e) und vor Stufe (f) oxidiert wird.

**Revendications**

1. Procédé de fabrication d'un dispositif à semiconducteur par utilisation d'un isolement d'élément d'une région active dans un substrat semi-conducteur, par formation de matériaux isolants, le procédé comprenant les étapes suivantes:

(a) la formation d'une couche (3) de matériau oxydable sur une surface du substrat semi-conducteur (1),

(b) la formation d'un masque d'oxydation (4) sur une partie de la couche (3) du matériau oxydable qui recouvre la région active,

(c) l'oxydation d'une partie ou de la totalité de la couche (3) du matériau oxydable qui n'est pas recouverte par le masque (4) d'oxydation avec formation d'une couche (6) d'oxyde destinée à l'isolement d'élément,

(d) l'enlèvement du masque (4) d'oxydation,

(e) l'exposition partielle de la surface du substrat semi-conducteur (1) par enlèvement d'une partie au moins de la couche (3) du matériau oxydable que est exposée par l'étape d'enlèvement du masque (4) d'oxydation, et

(f) la formation d'un élément à semi-conducteur à la surface exposée du substrat semi-conducteur (1).

2. Procédé selon la revendication 1, dans lequel une étape de dopage d'une impureté dans une région de formation d'une couche d'oxyde du substrat semi-conducteur (1) est exécutée avant l'étape d'oxydation d'une partie ou de la totalité de la couche (3) du matériau oxydable.

3. Procédé selon la revendication 1, dans lequel une couche (2) d'oxyde est disposée entre le substrat semi-conducteur (1) et la couche (3) du matériau oxydable.

4. Procédé selon la revendication 1, dans lequel le masque (4) d'oxydation est formé de nitrure de silicium.

5. Procédé selon la revendication 2, dans lequel un matériau de réserve photographique destiné à la formation du masque (4) d'oxydation est utilisé comme masque de dopage dans l'étape de dopage de l'impureté.

6. Procédé selon la revendication 5, dans lequel la surface du masque (4) d'oxydation est supérieure à celle du matériau de réserve photographique.

7. Procédé selon la revendication 1, dans lequel l'étape d'oxydation d'une partie de la couche (3) du matériau oxydable provoque la formation d'une couche d'oxyde constituant une couche supérieure et la formation d'une couche protectrice non oxydée sous forme d'une couche inférieure.

8. Procédé selon l'une quelconque des revendications 1 à 7, dans lequel le matériau oxydable est du silicium non monocristallin.

9. Procédé selon l'une quelconque des revendications 1 à 7, dans lequel le materiau oxydable est un matériau qui s'oxyde plus rapidement que le substrat semi-conducteur (1).

10. Procédé selon la revendication 9, dans lequel le matériau qui s'oxyde plus rapidement que le substrat semi-conducteur (1) est au moins un matériau choisi dans le groupe qui comprend le silicium polycristallin ayant une concentration élevée d'impureté, le siliciure de molybdène et le siliciure de tungstène.

11. Procédé selon la revendication 1, dans lequel une couche supérieure du matériau oxydable exposée par l'étape d'enlèvement du masque d'oxydation est oxydée après l'étape (e) et avant l'étape (f).

FIG. 1 (a)

FIG. 1 (b)

FIG. 1 (c)

FIG. 1 (d)

FIG. 1 (e)

FIG. 1 (f)

FIG. 2(a)

FIG. 2(b)

FIG. 2(c)

FIG. 2(d)

FIG. 2(e)

FIG. 2(f)

FIG. 3(a)

FIG. 3(b)

FIG. 3(c)

FIG. 3(d)

FIG. 4

FIG. 5(a)

FIG. 5(b)

FIG. 5(c)

FIG. 5(d)

FIG. 6

FIG.7(a)

FIG.7(b)

FIG.7(c)

FIG.7(d)

FIG. 8

FIG. 9